(19)

Europäisches
Patentamt

European
Patent Office

Office européen
des brevets

(11)  **EP 4 524 588 B1**

(12)  **EUROPEAN PATENT SPECIFICATION**

(45) Date of publication and mention
of the grant of the patent:
**18.03.2026  Bulletin 2026/12**

(21) Application number: **24195596.2**

(22) Date of filing: **21.08.2024**

(51) International Patent Classification (IPC):
**G01R 31/54** (2020.01)      **G01R 15/20** (2006.01)
**B23K 9/095** (2006.01)

(52) Cooperative Patent Classification (CPC):
**G01R 15/202; B23K 9/0956; G01R 31/54**

(54) **WELDING POWER SUPPLY WITH DETECTION OF A DISCONNECTION FOR A HALL CURRENT DETECTOR**

SCHWEISSSTROMVERSORGUNG MIT DETEKTION EINER TRENNUNG FÜR EINEN HALLSTROMDETEKTOR

ALIMENTATION DE SOUDAGE AVEC DÉTECTION D'UNE DÉCONNEXION POUR UN DÉTECTEUR DE COURANT À EFFET HALL

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **15.09.2023  JP 2023150107**

(43) Date of publication of application:
**19.03.2025  Bulletin 2025/12**

(73) Proprietor: **DAIHEN Corporation**
**Yodogawa-ku**
**Osaka-shi**
**Osaka 532-8512 (JP)**

(72) Inventors:
• **Onishi, Takanori**
**Osaka, 532-8512 (JP)**
• **Manabe, Haruhiko**
**Osaka, 532-8512 (JP)**

(74) Representative: **Boult Wade Tennant LLP**
**Salisbury Square House**
**8 Salisbury Square**
**London EC4Y 8AP (GB)**

(56) References cited:
**EP-A1- 4 088 853       CN-A- 112 415 430**
**JP-A- 2009 232 261**

EP 4 524 588 B1

**Description**

FIELD

The present disclosure generally relates to detection of a disconnection for a Hall current detector.

BACKGROUND

A method for detecting a disconnection in the power supply line to a Hall element is already known (see, for example, JP-A-2009-232261 and CN112415430 A). By the conventional method, the disconnection in the power supply line is detected by detecting that no electric current is flowing through the Hall element.

Conventionally, however, it is not possible to detect a disconnection in the output line of a Hall current detector, which can occur, for example, due to the breakage of the line (wires) or the disconnection of the line from a connector (the line's coming loose from the connector).

SUMMARY

The present disclosure has been made to solve the problem noted above and aims to enable detection of a disconnection in the output line of a Hall current detector.

To solve the problem noted above, according to a first aspect of the present disclosure, there is provided a disconnection detecting device including: a Hall current detector that detects a welding current flowing through a welding power supply; a power supply circuit that provides a control power to the Hall current detector; a bias resistor connected to an output of the Hall current detector and the control power; and an output-line disconnection detection circuit that detects a disconnection in an output line of the Hall current detector. The output-line disconnection detection circuit is configured to determine that the output line of the Hall current detector has a disconnection, based on an output voltage of the Hall current detector being equal to or higher than a predetermined reference voltage while the welding power supply is off.

According to a second aspect of the present disclosure, the disconnection detecting device further includes a switch connected between the bias resistor and the control power. The switch is configured to close when the welding power supply is off and to open when the welding power supply is on.

The present disclosure enables detection of a disconnection in the output line of a Hall current detector.

DRAWINGS

Fig. 1 is a circuit diagram according to Embodiment 1 of the present disclosure.
Fig. 2 is a circuit diagram according to Embodiment 2 of the present disclosure.

EMBODIMENTS

With reference to the drawings, embodiments of the present disclosure will be described.

Embodiment 1:

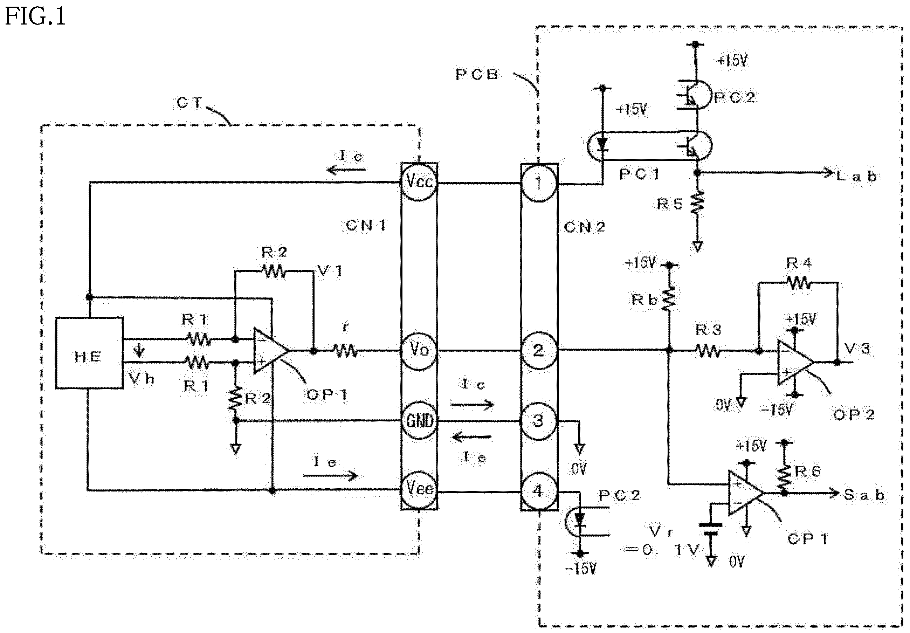

Fig. 1 is a circuit diagram according to Embodiment 1 of the present disclosure. With reference to the figure, the circuit operation is described below.

A Hall current detector CT detects the welding current flowing through a welding power supply (not shown) and outputs a voltage proportional to the welding current via a terminal Vo of a connector CN1 of the Hall current detector CT. The Hall current detector CT is supplied with control power from a control printed circuit board PCB through a connector CN2. Specifically, the control power is supplied to terminals Vcc, Vee, and GND of the connector CN1 as follows.

(1) A positive voltage of 15 volts is applied between the terminal Vcc and the terminal GND from a positive control power supply of +15 V through a light-emitting diode of a photocoupler PC1. This causes a positive control current Ic to flow to drive a Hall element HE and an operational amplifier OP1.

(2) A negative voltage of 15 volts is applied between the terminal Vee and the terminal GND from a negative control power supply of -15 V through an LED of a photocoupler PC2. This causes a negative control current Ie to flow to drive the Hall element HE and the operational amplifier OP1.

In the Hall current detector CT, the operational amplifier OP1 with resistors R1 and R2 amplifies (performs differential amplification of) the output signal Vh of the Hall element HE, which is proportional to the welding current that flows through the welding power supply, and outputs a voltage V1, which is also proportional to the welding current. In one example, it is designed such that the voltage V1 is equal to 1.00 V when the welding current is 100 A. An output protection resistor r (about 100 Ω) is connected between the output of the operational amplifier OP1 and the terminal Vo of the connector CN1 to protect the operational amplifier OP1.

An operational amplifier OP2 with resistors R3 and R4 inverts and amplifies the voltage V2 at the terminal Vo. For example, with the resistor R3 having a resistance of 10 kΩ (R3 = 10 kΩ) and the resistor R4 having a resistance of 5 kΩ (R4 = 5kΩ), the voltage V2 is inverted and amplified by a factor of 1/2.

The connector CN2 of the control printed circuit board PCB includes pins 1 to 4. A bias resistor Rb (about 300 kΩ) is connected at one end to the pin 2 and at the other end to the control power supply of +15 V. When the welding power supply is turned off (i.e. the output voltage is 0 V) and hence the welding current is 0 A, the output voltage V1 of the operational amplifier OP1 of the Hall current detector CT is also 0 V. At this time, however, a small voltage is added to the pin 2 due to the presence of the output protection resistor r, where the voltage V2 at the pin 2 is given by the expression below.

$$V2 = 15 \ V \times r/(Rb + r) = 15 \ V \times 100/(300k + 100)$$
$$= 5 \ mV$$

If there is a disconnection between the terminal Vo and the pin 2 due to line breakage, line's disconnection from the connector or so forth, while the welding power supply is off and hence the welding current is 0 A, then the voltage V2 at the pin 2 is as given by the expression below, due to the bias resistor Rb.

$$V2 = 15 \ V \times R3/(Rb + R3) = 15 \ V \times 10k/(300k + 10k)$$
$$= 0.48 \ V$$

A comparator CP1 compares the voltage V2 at the pin 2 and a reference voltage Vr. When determining that the voltage V2 exceeds the reference voltage Vr, the comparator CP1 switches its output from Low (0 V) to High (15 V) to set an output-line disconnection signal Sab to High. The reference voltage Vr is set to about 0.1 V, for example. When there is a disconnection between the terminal Vo and the pin 2, the voltage V2 (0.48 V) exceeds the reference voltage Vr (0.1 V) while the welding power supply is being off. This causes the output-line disconnection signal Sab to switch to High, enabling the disconnection to be detected.

The following describes how to detect a disconnection between each terminal of the connector CN1 of the Hall current detector CT and the corresponding pin of the connector CN2 of the control printed circuit board PCB.

Disconnection between Vcc and Pin 1:

If there is a disconnection between the terminal Vcc and the pin 1 of the connector CN2 of the control printed circuit board PCB, no control current Ic flows through the Hall current detector CT and no current flows through the LED of the photocoupler PC1. Consequently, the phototransistor of the photocoupler PC1 goes off, so that a control-line disconnection signal Lab is set to Low (0 V) to indicate the disconnection.

Disconnection between Vee and Pin 4:

If there is a disconnection between the terminal Vee and the pin 4 of the connector CN2 of the control printed circuit board PCB, no control current Ie flows through the Hall current detector CT and no current flows through the LED of the photocoupler PC2. Consequently, the phototransistor of the photocoupler PC2 goes off, so that the control-line disconnection signal Lab is set to Low (0 V) to indicate the disconnection.

Disconnection between GND and Pin 3:

If there is a disconnection between the terminal GND and the pin 3 of the connector CN2 of the control printed circuit board PCB, nether of control currents Ic and Ie flows through the Hall current detector CT and no current flows through the LED of the photocouplers PC1 and PC2. Consequently, the phototransistors of the photocouplers PC1 and PC2 go off, so that the control-line disconnection signal Lab is set to Low (0 V) to indicate the disconnection.

Disconnection between Vo and Pin 2:

When there is a disconnection between the terminal Vo and the pin 2 of the connector CN2 of the control printed circuit board PCB, the voltage V2 at the pin 2 is equal to 0.48 V and thus exceeds the reference voltage Vr of 0.1 V (V2 > Vr) while the welding power supply is off and hence no welding current flows. Consequently, the output of the comparator CP1 is switched to High (15 V), so that the output-line disconnection signal Sab is set to High to indicate the disconnection.

## EP 4 524 588 B1

Embodiment 2

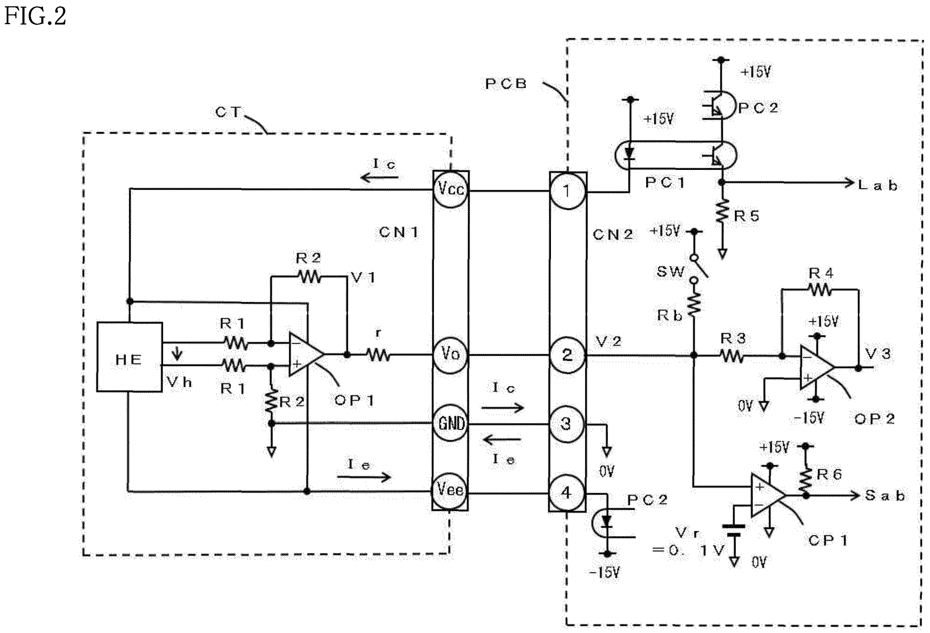

Fig. 2 is a circuit diagram according to Embodiment 2 of the present disclosure. With reference to the figure, only the circuit operation different from that of the Embodiment 1 will be described below.

In Embodiment 1, the bias resistor Rb is always connected to the control power supply of +15 V and the pin 2. Thus, the bias voltage of 5 mV due to the bias resistor Rb is added to the output voltage V2 of the Hall current detector CT at all times even when the welding power supply is on. Consequently, when the welding current of the welding power supply is AC current (i.e., a combination of positive current and negative current), a signal of 5 mV (0.5 A) acts as an addition for the positive current, while it acts as an subtraction for the negative current. This varies the magnitude of the negative and positive currents.

To address the above issue, a switch SW is provided between the control power supply of + 15V and the bias resistor Rb as shown in Fig. 2. During the time the welding power supply is off, the switch SW is closed so that the bias resistor Rb is connected between the control power supply of +15 V and the pin 2 to enable the detection of a disconnection between the terminal Vo and the pin 2. During the time the welding power supply is off, the switch SW is open to prevent the bias voltage due to the bias resistor Rb from being added to the pin 2. This prevents the undesirable variation between the positive and negative currents while the welding power supply is on.

The circuit diagrams of Embodiments 1 and 2 shown in Figs. 1 and 2 are presented as examples and not as limitations. For instance, the switch SW may be implemented by a relay with mechanically opened and closed contacts or by a semiconductor switch, such as a P-channel metal-oxide-semiconductor field-effect transistor (MOSFET) or an other analog switch.

REFERENCE NUMERALS

CN1, CN2 connector
CP1 comparator
CT Hall current detector
HE Hall element
Ic, Ie control current
Lab control-line disconnection signal
OP1, OP2 operational amplifier
PC1, PC2 photocoupler
PCB printed circuit board
r, R1 to R6 resistor
Rb bias resistor
Sab output-line disconnection signal
SW switch
V1 to V3 output voltage
Vh output signal
Vr reference voltage

**Claims**

1. A disconnection detecting device comprising:

    a Hall current detector (CT) that detects a welding current flowing through a welding power supply;
    a power supply circuit that provides a control power to the Hall current detector (CT);
    a bias resistor (Rb) connected to an output of the Hall current detector (CT) and the control power; and
    an output-line disconnection detection circuit that detects a disconnection in an output line of the Hall current detector (CT),

    wherein the output-line disconnection detection circuit is configured to determine that the output line of the Hall current detector (CT) has a disconnection, based on an output voltage of the Hall current detector (CT) being equal to or higher than a predetermined reference voltage (Vr) while the welding power supply is off.

2. The disconnection detecting device according to claim 1, further comprising a switch (SW) connected between the bias resistor (Rb) and the control power,
wherein the switch (SW) is configured to close when the welding power supply is off and to open when the welding power supply is on.

**Patentansprüche**

1. Eine Vorrichtung zur Erkennung von Unterbrechungen, umfassend:

   einen Hall-Stromdetektor (CT), der einen durch eine Schweißstromquelle fließenden Schweißstrom erfasst;
   eine Stromversorgungsschaltung, die den Hall-Stromdetektor (CT) mit Steuerstrom versorgt;
   einen Vorspannungswiderstand (Rb), der mit einem Ausgang des Hall-Stromdetektors (CT) und der Steuerspannung verbunden ist; und
   eine Ausgangsleitungs-Trennungserkennungsschaltung, die eine Trennung in einer Ausgangsleitung des Hall-Stromdetektors (CT) erkennt,

   wobei die Ausgangsleitungs-Trennungserkennungsschaltung so konfiguriert ist, dass sie feststellt, dass die Ausgangsleitung des Hall-Stromdetektors (CT) eine Trennung aufweist, basierend darauf, dass eine Ausgangsspannung des Hall-Stromdetektors (CT) gleich oder höher als eine vorbestimmte Referenzspannung (Vr) ist, während die Schweißstromversorgung ausgeschaltet ist.

2. Die Trennungserkennungsvorrichtung gemäß Anspruch 1, die ferner einen Schalter (SW) umfasst, der zwischen dem Vorspannungswiderstand (Rb) und dem Steuerstrom angeschlossen ist, wobei der Schalter (SW) so konfiguriert ist, dass er schließt, wenn die Schweißstromversorgung ausgeschaltet ist, und öffnet, wenn die Schweißstromversorgung eingeschaltet ist.

**Revendications**

1. Dispositif de détection de déconnexion comprenant:

   un détecteur de courant à effet Hall (CT) qui détecte un courant de soudage circulant dans une alimentation de soudage;
   un circuit d'alimentation qui fournit une tension de commande au détecteur de courant à effet Hall (CT);
   une résistance de polarisation (Rb) connectée à une sortie du détecteur de courant à effet Hall (CT) et à l'alimentation de commande; et
   un circuit de détection de déconnexion de ligne de sortie qui détecte une déconnexion sur une ligne de sortie du détecteur de courant à effet Hall (CT),
   où le circuit de détection de déconnexion de ligne de sortie est configuré pour déterminer que la ligne de sortie du détecteur de courant à effet Hall (CT) a une déconnexion sur la base de ce qu'une tension de sortie du détecteur de courant à effet Hall (CT) est égale ou supérieure à une tension de référence (Vr) prédéterminée tandis que l'alimentation de soudage est éteinte.

2. Dispositif de détection de déconnexion selon la revendication 1, comprenant en outre un interrupteur (SW) connecté entre la résistance de polarisation (Rb) et l'alimentation de commande, où l'interrupteur (SW) est configuré pour se fermer lorsque l'alimentation de soudage est éteinte et pour s'ouvrir lorsque l'alimentation de soudage est allumée.

FIG.1

FIG.2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009232261 A

- CN 112415430 A